## Europäisches Patentamt
## European Patent Office
## Office européen des brevets

(19)

(11) Numéro de publication: **0 014 757**
**B1**

(12) **FASCICULE DE BREVET EUROPÉEN**

(45) Date de publication du fascicule du brevet:
**08.04.87**

(21) Numéro de dépôt: **79105165.9**

(22) Date de dépôt: **14.12.79**

(51) Int. Cl.⁴: **G 06 F 11/00, H 02 H 3/24,
G 01 R 19/165**

(54) Circuit détecteur de défauts survenant sur une ligne d'alimentation.

(30) Priorité: **26.02.79 US 15268**

(43) Date de publication de la demande:
**03.09.80 Bulletin 80/18**

(45) Mention de la délivrance du brevet:
**08.04.87 Bulletin 87/15**

(84) Etats contractants désignés:
**DE FR GB**

(56) Documents cité:
**FR-A-2 156 671**
**FR-A-2 292 276**
**US-A-3 618 015**
**US-A-4 031 464**

**IBM TECHNICAL DISCLOSURE BULLETIN, vol.
17, no.8, janvier 1975, New York US STAMMELY: "
Line voltage threshold detector"; pages 2380-2382**

(73) Titulaire: **International Business Machines
Corporation, Old Orchard Road, Armonk, N.Y.
10504 (US)**

(72) Inventeur: **Driscoll, Carleton, David, 902 Palmetto
Dr., Cary, NC 27511 (US)**
Inventeur: **Hobbs, Jr., James Norwood, 415 Sorrell
Street, Cary, NC 27511 (US)**

(74) Mandataire: **Colas, Alain, Compagnie IBM France
Département de Propriété Intellectuelle, F-06610
La Gaude (FR)**

## Description

La présente invention concerne un circuit détecteur de défauts survenant sur une ligne d'alimentation pour un système de traitement de données comme exposé dans le préambule de la revendication. Un tel détecteur est connu du document intitulé "Line Voltage Threshold Detector" paru dans "IBM Technical Disclosure Bulletin", vol 17, n°8 de janvier 1975 pages 2380/2.

## Etat de la Technique Antérieure

Les données manipulées dans un système électronique de traitemént de données, n'existent, dans la plupart des cas, que sous forme volatile. Ces données vont être perdues ou fortement dénaturées s'il y a coupure de l'alimentation électrique du système.

Lorsque la perte d'énergie peut être prévisible, par exemple, lors de l'interruption du système de traitement de données pour des raisons de maintenance ou à la fin des heures normales de travail, on procède à des opérations de routine pour conserver toutes les données volatiles en les transférant sur un milieu d'emmagasinage non volatil, par exemple, sur des disques magnétiques ou des bandes magnétiques.

Cependant, il y à des cas où la perte dans l'alimentation en énergie du système n'est pas prévisible. La source d'alimentation principale peut ne pas fonctionner sur des périodes de temps s'étalant d'un cycle à deux ou plusieurs jours, à la suite de conditions atmosphériques, de surcharges, etc.. Il est important que le système de traitement de données soit capable de reconnaître les défauts alors présents sur la ligne d'alimentation et d'y répondre aussi rapidement que possible afin d'avoir le maximum de temps pour que les données volatiles puissent être transférées régulièrement sur un moyen d'emmagasinage non volatil.

Quelquefois, les défauts présents sur une ligne d'alimentation sont extrêmement brefs. Afin de réduire au minimum le temps durant lequel le système n'est plus en état de fonctionner, il est également important que le système puisse répondre de façon cohérente aux signaux indiquant que l'alimentation du système a été restaurée après la perturbation sur la ligne d'alimentation.

Dans de nombreux systèmes de l'art antérieur, le même circuit remplit les fonctions de détection de défauts sur la ligne d'alimentation et de rétablissement de l'alimentation. Le circuit comprend un circuit comparateur-amplificateur ayant une première entrée connectée à une source d'alimentation du système à travers un diviseur de tension à résistance. Une seconde entrée appliquée au circuit comparateur-amplificateur est connectée à la source d'alimentation du système à travers un circuit de charge à résistance-condensateur (RC). Lorsque le système vient à être mis sous alimentation, la tension à la première entrée va s'élever immédiatement alors que la tension à la seconde entrée va s'élever à une taux plus faible suivant la constante de temps du circuit de charge. Après un retard prédéterminé, la tension sur la seconde entrée va dépasser la tension sur la première entrée, ce qui provoque la commutation de la sortie du circuit comparateur-amplificateur. Le nouveau signal de sortie de l'amplificateur sert de signal de rétablissement de l'alimentation.

Dans le cas de perte de l'alimentation du système, la première entrée appliquée à l'amplificateur va chuter immédiatement alors que la seconde entrée va chuter à un taux plus faible du fait de la décharge du condensateur. Lorsque le condensateur s'est déchargé à un niveau prédéterminé, la sortie de l'amplificateur va être commutée, fournissant un signal de perturbation de la ligne d'alimentation qui peut être utilisé pour amorcer les operations de preservation des données.

Ce circuit à double fonction présente un certain nombre d'inconvénients. Tout d'abord, les deux fonctions que doit remplir le circuit ne vont pas de pair. Pour que les tensions du système aient le temps de se stabiliser lors de la première application de l'alimentation, la constante de temps du circuit de charge RC doit être relativement grande. Cependant, si la constante de temps est grande, le condensateur va se décharger lentement lors de l'apparition d'une perturbation sur la ligne d'alimentation. En conséquence, le signal indiquant cette perturbation sur la ligne d'alimentation (signal PLD) va être engendré plus tard qu'il ne le devrait de manière idéale. Il est évident que la réponse du circuit à une perturbation sur la ligne d'alimentation pourrait être améliorée en réduisant la constante de temps du circuit de charge. Ceci diminue nécessairement le temps disponible pour la stabilisation des tensions continues du système lorsque le système est mis sous alimentation.

Un autre problème rencontré dans le circuit classique à double fonction réside en ce que ce circuit ne répond pas de façon fiable dans le cas où la coupure de l'alimentation est brève. Dans le cas où le défaut surversant sur la ligne d'alimentation est bref, le condensateur de délai ne va pas avoir le temps de se décharger totalement. En conséquence, lorsque l'alimentation est remise en route, le condensateur de délai atteint trop tôt le niveau de commutation, ce qui va se traduire par l'application d'un signal de restauration prématuré. Si les tensions continues du système ne se sont pas stabilisées, le signal de restauration prématuré va entraîner des erreurs dans le fonctionnement du système.

Un autre problème rencontré avec un circuit à double fonction réside dans la variation des périodes de délai par suite des tolérances des composants passifs. En effet, à moins d'employer des composants de faible tolérance, qui sont coûteux, différents systèmes vont répondre à des temps différents lorsque le système va être mis sous tension ou hors tension.

Le circuit fondamental à double fonction présente des variantes connues. Dans une de ces variantes, le circuit de charge RC comprend une deuxième résistance montée en parallèle avec le condensateur de délai. La sortie du comparateur-amplificateur fournit une tension de commutation à un transistor connecté à un condensateur dans un deuxième circuit de charge RC. Le deuxième circuit de charge RC est connecté à une source d'alimentation continue du système et envoie une entrée à un deuxième comparateur-amplificateur. L'autre entrée appliquée au comparateur-amplificateur est un diviseur de tension à résistance qui est également connecté à la source d'alimentation continue.

Les composants passifs aux entrées appliquées au deuxième comparateur-amplificateur remplissent les fonctions de délai lors de la détection d'un défaut survenant sur la ligne d'alimentation et lors de la remise sous tension. Le premier comparateur-amplificateur, ainsi que son circuit associé, sont utilisés pour décharger rapidement le deuxième condensateur de délai dans le cas où il y a une perturbation sur la ligne d'alimentation, si bien que le signal de la remise sous alimentation (POR) va être engendré uniquement après un temps fixe quelle que soit la durée de l'interruption de l'alimentation.

Bien que ce circuit résout le problème du redémarrage prématuré, le temps de réponse du système à une perturbation sur la ligne d'alimentation peut toujours varier grandement par suite des tolérances des composants passifs.

Le document US.A.3 937 937 décrit un autre type de détecteur de défaut d'alimentation primaire, dans lequel il y a multiplication de signaux électriques dépendant des valeurs algébriques de la tension et du courant de l'alimentation. Lorsqu'il y aura panne d'alimentation, la sortie du multiplicateur va indiquer un renversement du flux d'alimentation. Un circuit monocoup pouvant être redéclenché est utilise simultanément avec une porte ĒT̄ afin de détecter la chute de tension instantanée à zéro et l'inversion du courant afin d'engendrer un signal de défaut d'alimentation.

Il n'est pas évident que ce détecreur de défaut d'alimentation réponde de façon fiable lors d'une baisse d'alimentation, c'est-à-dire lorsque la fréquence de l'énergie alternative primaire va être maintenue alors que son amplitude va être réduite par suite des conditions de surcharge. En outre, il apparaît que le temps de réponse du circuit détecteur de défaut d'alimentation est fixe et qu'il ne peut pas être réglé pour permettre l'utilisation de système de traitement de données présentant diverses conditions requises. Par exemple, un type de système de traitement de données peut être capable de tolérer des coupures d'alimentation de durées plus longues que d'autres types de système. Il est souhaitable que la détection de la panne d'alimentation soit adaptée au niveau de ce que peut tolérer le système comme panne d'alimentation.

Plus précisément, le document FR-A-2 156 671 décrit un appareil pour contrôler l'apparition de demi-cycles inférieurs aux demi-cycles normaux dans une alimentation en courant alternatif; il comprend plus particulièrement un circuit comparateur de la tension alternative à une tension de référence afin de produire un signal chaque fois que la tension de la forme d'onde d'entrée excède une proportion prédéterminée de la tension de référence. Dans ce cas le signal produit par le comparateur décharge le condensateur d'un générateur en dents de scie. Si le condensateur n'est pas déchargé un commutateur sensible à l'amplitude excite les marteaux d'impression d'une imprimante pour imprimer le nombre de cycles pendant lesquels la tension de seuil n'a pas été atteinte.

Ce dispositif utilisant un dispositif analogique présente les inconvénients des dispositifs analogiques déjà mentionnés. De plus, il n'a pas pour objet la sauvegarde du système et le rétablissement de l'alimentation mais un simple but d'enregistrement.

Le document US-A-4 031 464 présente un dispositif pour tester la distorsion d'un signal alternatif d'alimentation pouvant être utilisé dans un système de traitement de données. Il comporte un compteur numérique permettant de mesurer le temps qui s'écoule entre une valeur du signal représentant 20% et une autre représentant 85% de la valeur de pic du signal. Si le compte du compteur se trouve en dehors d'une gamme prédéterminée de valeurs un signal d'erreur est émis. Le compteur est restauré à chaque cycle de signal. Le but du dispositif décrit dans ce document est uniquement de détecter les distorsions du signal et non son absence ou son insuffisance; d'autre part le principe de la mesure est limité à la détection du temps s'écoulant entre les deux niveaux bien déterminés du signal.

**Exposé de l'Invention**

La présente invention est un détecteur qui est très sensible aux défants survenant sur une ligne d'alimentation et qui offre des caractéristiques de fonctionnement qui peuvent être facilement réglées de manière à être utilisées avec des systèmes qui présentent des tolérances différentes aux défauts survenant sur une ligne d'alimentation.

Un détecteur de défauts survenant sur une ligne d'alimentation réalisé conformément à la présente invention, est décrit dans la revendication 1 et est caractérisé par les moyens exposés dans la partie caractérisante de cette revendication.

D'autres objets, caractéristiques et avantages de la présente invention ressortiront mieux de l'exposé qui suit, fait en référence aux dessins annexés à ce texte, qui représentent un mode de réalisation préféré de celle-ci.

### Brève Description des Dessins

La figure 1 représente un diagramme général d'un circuit détecteur de défauts survenant sur une ligne d'alimentation construit conformément à la présente invention, et

La figure 2 représente de façon plus détaillée quelques unes des portions du circuit représenté sur la figure 1.

### Description d'un Mode de Réalisation

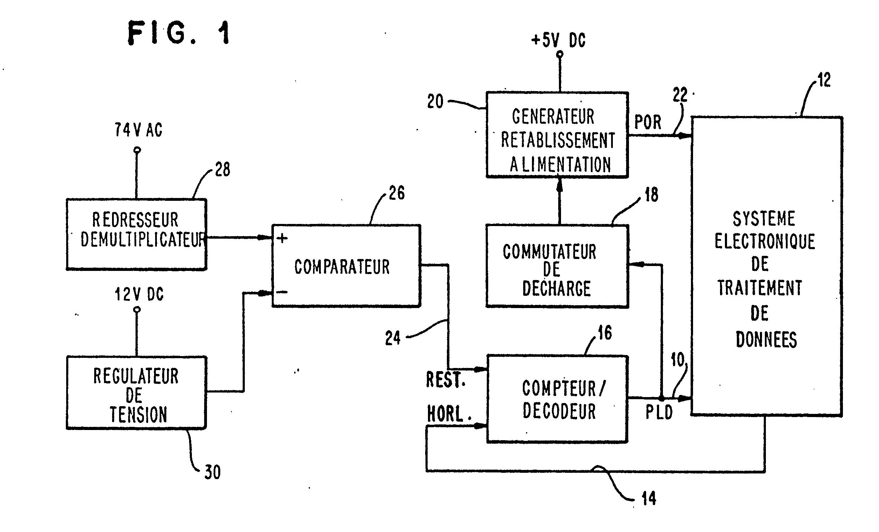

En référence à la figure 1, un circuit détecteur construit conformément aux principes de la présente invention, est utilisé pour fournir un signal de perturbation sur la ligne d'alimentation (PLD) à une ligne d'entrée 10 connectée à un système électronique de traitement de données représenté sous forme schématique par le bloc 12. Le système 12, qui peut être classique, comprend un ou plusieurs circuits d'horloge pour produire des impulsions d'horloge à des cadences rigoureusement contrôlées. Les impulsions d'horloge engendrées à une de ces sources sont appliquées au circuit PLD, par l'entremise d'une ligne de sortie 14, en provenance du système 12. Les impulsions d'horloge sont utilisées pour incrémenter un circuit compteur/décodeur 16 qui va être décrit de façon plus détaillée dans la suite. La ligne de signal PLD 10 à la sortie du circuit 16 est utilisée pour commander un commutateur de décharge 18 associé à un circuit générateur d'impulsions de rétablissement de l'alimentation 20. Un signal de rétablissement de l'alimentation (POR) sur une ligne de sortie 22 en provenance du circuit 20 est renvoyé au système 12 pour amorcer les registres et compteurs du système lorsque le système est à nouveau alimenté.

Une impulsion de restauration 24 est appliquée au circuit compteur/décodeur 16 par un circuit comparateur 26 qui compare un signal alternatif fourni par un circuit redresseur/démultiplicateur 28 avec un signal de tension continue régulée fournie par un circuit régulateur de tension 30. Le circuit 28 est attaqué par la source d'alimentation alternative primaire du système. L'alimentation alternative est redressée et démultipliée avant d'être comparée à une tension de seuil fournie par le régulateur de tension 30. Aussi longtemps que l'alimentation alternative est maintenue à des valeurs normales, l'amplitude du signal fourni par le circuit 28 dépasse le niveau de seuil continu au moins une fois durant chaque cycle de l'alimentation alternative primaire. La sortie du circuit comparateur 26 change en conséquence aussi longtemps que l'alimentation alternative est maintenue pour fournir au moins une impulsion de restauration durant chaque cycle d'alimentation alternative.

L'impulsion de restauration restaure la portion de comptage du circuit compteur/décodeur 16 à une valeur initiale prédéterminée, de préférence zéro. La portion de comptage va immédiatement commencer à incrémenter le compte à une cadence prédéterminée par les impulsions d'horloge fournies à partir du système 12 sur la ligne 14. La portion de décodage du circuit compteur/décodeur 16 est sensible à un compte prédéterminé de déclenchement pour fournir le signal PLD sur la ligne 10. Le compte de déclenchement dépasse la gamme des comptes atteints entre les impulsions de restauration qui apparaissent normalement. C'est-à-dire, aussi longtemps que l'alimentation alternative est maintenue, la section de comptage est ramenée à zéro avant que le compteur ne puisse atteindre le compte de déclenchement.

Lorsque le signal PLD est engendré, il est appliqué au système 12 ainsi qu'au commutateur de décharge 18. Le système 12 répond au signal PLD en appelant et en exécutant une routine pour transférer les données volatiles critiques sur une mémoire non volatile avant que l'alimentation du système ne soit complètement perdue. Le signal PLD permet au commutateur de décharge 18 de restaurer ou de mettre en marche le circuit générateur de rétablissement de l'alimentation 20 pour que ce circuit 20 puisse répondre uniquement après un temps fixe quel que soit le moment où se fasse le rétablissement de l'alimentation. Lorsque l'alimentation a été restaurée à un niveau convenable au bon fonctionnement du système, le signal POR va être envoyé au système 12, par la ligne 22.

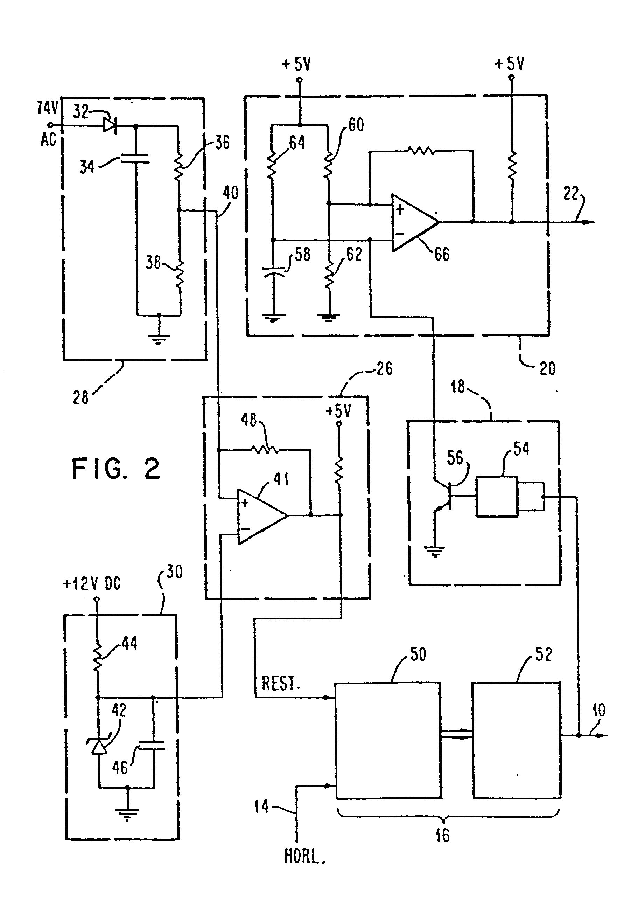

La figure 2 montre de façon plus détaillée certains des composants fonctionnels de la figure 1. Le circuit redresseur/démultiplicateur 28 comprend, de préférence, une diode 32 qui joue le rôle de redresseur demi-onde pour la tension alternative fournie, de préférence, à partir d'une source primaire d'alimentation alternative de 74 volts crête-à-crête. La diode 32 est connectée à un condensateur de suppression de bruit 34 ainsi qu'à l'extrémité supérieure d'un diviseur de tension formé par les résistances 36 et 38. Le condensateur 34 et la résistance 38 sont connectés dans le système à la masse. Dans un mode de réalisation préféré de la présente invention, les valeurs relatives des résistances 36 et 38 sont telles que l'impulsion de pente positive à une ligne de sortie 40 a une amplitude de crête de 12,5 volts dans les conditions d'alimentation normale. L'impulsion de pente positive est appliquée à l'entrée positive d'un circuit comparateur-amplificateur 41 dans le circuit comparateur 26. L'entrée de référence appliquée au circuit 41 est fournie par le régulateur de tension 30 qui comprend une diode Zener 42 et une résistance 44 connectées en série entre une source de tension continue positive et la masse. Un condensateur de maintien 46 est connecté en parallèle à la diode Zener 42. La tension de rupture inverse de la diode Zener 42 est de préférence de l'ordre de 6 volts. La diode 42 et le condensateur de maintien 46 permettent à cette tension d'être maintenue à l'entrée de référence appliquée au circuit comparateur-amplificateur 41.

Comme cela a été mentionné ci-dessus, chaque impulsion de pente positive fournie par un circuit redresseur/démultiplicateur 26 a une amplitude de crête de l'ordre de 12,5 volts dans les conditions d'alimentation normale. Au moins une fois durant chaque cycle normal de l'alimentation alternative primaire, l'impulsion envoyée au circuit comparateur-amplificateur 26 dépasse l'entrée de référence, ce qui permet à la sortie de l'amplificateur de devenir positive. Une boucle d'hystérésis comprenant une résistance 48 assure la rapidité de l'opération de commutation.

L'impulsion de pente positive à la sortie du circuit comparateur-amplificateur 26 fournit l'impulsion de restauration au compteur numérique 50. Le compteur numérique 50 peut être un compteur binaire classique qui peut être restauré à un compte initial prédéterminé, par exemple zéro, chaque fois qu'est reçue une impulsion de restauration. La cadence à laquelle le compteur numérique 50 est incrémentée est fixée par la fréquence de la séquence des impulsions d'horloge fournies à partir du système de traitement de données associé, par la ligne 14.

Le contenu binaire du compteur numérique 50 est envoyé à un circuit décodeur 52 qui est simplement un circuit logique sensible à un compte prédéterminé se trouvant dans le compteur 50 pour fournir une impulsion de sortie de pente positive. Ce compte prédéterminé ou de déclenchement dépasse la gamme des comptes normalement atteints dans le compteur 50 entre des impulsions de restauration. Dans un système de 60 hertz, les impulsions de restauration vont normalement apparaître toutes les 16,7 millisecondes. Le compte de déclenchement va être fixé à un niveau qui va être atteint dans un temps légèrement plus long. Par exemple, le compte de déclenchement pourrait exiger 21 millisecondes pour être atteint à la fréquence des impulsions d'horloge envoyées sur la ligne 14. Aussi longtemps que l'alimentation alternative est maintenue, le compteur numérique 50 ne va jamais atteindre le compte de déclenchement et les sorties du décodeur 52 vont rester à un niveau bas. Cependant, si un cycle d'alimentation alternative vient à être sauté, ou si l'amplitude de la tension d'alimentation alternative tombe en-dessous d'un niveau donné, l'absence d'impulsion de restauration va permettre au compteur numérique d'atteindre le compte de déclenchement. Le décodeur 52 va répondre en produisant une impulsion de sortie sur la ligne 10.

L'impulsion de sortie fournit le signal PLD requis par le système 12. Ce signal est également appliqué aux deux entrées d'une porte ET 54 du circuit de décharge 18. La porte ET 54 attaque un transistor 56 monté dans un trajet de décharge du condensateur 58 du circuit générateur de rétablissement de l'alimentation. Ce circuit est classique et comprend un premier diviseur de tension formé par les résistances 60 et 62 ainsi qu'un deuxième diviseur de tension formé par le condensateur 58 et une résistance 64.

Lorsque, après coupure, l'alimentation du système est rétablie, la tension à la jonction des résistances 60 et 62 va s'élever immédiatement à un niveau déterminé par la valeur relative des deux résistances et par l'amplitude de la tension restaurée. La tension à la jonction du condensateur 58 et de la résistance 64 va s'élever à un taux déterminé par la constante de temps du condensateur 58 et de la résistance 64. Après un temps prédéterminé, le condensateur 58 va se charger à une tension supérieure à la tension présente à la jonction des résistances 60 et 62. La sortie du circuit comparateur-amplificateur 66 va passer à un niveau bas afin de fournir le signal POR sur la ligne 22.

Durant les opérations normales du circuit, le condensateur 58 va être totalement chargé au potentiel de la source d'alimentation continue. Dans le cas où la coupure de l'alimentation·est brève, le condensateur 58 peut ne pas avoir le temps de se décharger complétement. Dans ces conditions, le rétablissement de l'alimentation qui s'ensuit, va faire que le signal POR va être engendré trop rapidement.

Pour être sûr que le signal POR est bien engendré au moment approprié, le signal PLD est utilisé pour mettre ou remettre en marche le circuit de rétablissement de l'alimentation, en déchargeant immédiatement le condensateur 58 à travers le transistor 56. Indépendamment du moment où est restaurée l'alimentation du système, le condensateur 58 doit toujours se recharger à partir du potentiel zéro, assurant ainsi que le signal POR ne sera engendré qu'après qu'un temps minimum prédéterminé se soit écoulé.

Le mode de réalisation de la présente invention qui vient d'être décrit utilise un redresseur demi-onde pour fournir une impulsion de restauration durant chaque cycle complet de la source d'alimentation alternative primaire. Si besoin est, le redresseur demi-onde pourrait être remplacé par un redresseur biphasé pour produire deux impulsions de restauration durant chaque cycle de la source d'alimentation alternative primaire. Le compte de déclenchement serait alors réglé en conséquence afin de fournir un signal PLD dans le cas où l'alimentation alternative viendrait à être perdue pendant même un demi-cycle. Inversement, le compte de déclenchement serait incrémenté pour fournir un signal PLD uniquement dans le cas où l'alimentation alternative serait perdue pendant un nombre prédéterminé de cycles supérieur à un cycle. Ainsi, le circuit peut-il être facilement adapté pour être utilisé avec des systèmes de traitement de données dont les niveaux de tolérance à des pannes d'alimentation sont variables.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Circuit détecteur de défauts survenant sur une ligne d'alimentation pour un système de traitement de données (12), comprenant:

1) un circuit comparateur (26) comparant une tension d'alimentation alternative à une tension de référence continue, ainsi que des moyens pour engendrer après cette comparaison un signal de défaut d'alimentation (PLD) envoyé au système de traitement de données (12), caractérisé en ce que le circuit comparateur produit une impulsion de restauration chaque fois qu'une valeur de crête de la tension alternative dépasse une valeur de seuil établie par la tension de référence continue, que les moyens précités comprennent un compteur numérique (50) ayant une entrée d'horloge provenant du système de traitement de données (12), et une entrée de restauration provenant dudit circuit comparateur, ce compteur étant incrémenté par l'horloge du système (12) et étant restauré à un compte initial prédéterminé par chaque impulsion de restauration fournie par le circuit comparateur (26),

2) un décodeur (52) sensible à un compte prédéterminé de déclenchement du compteur numérique (50) afin de produire le dit signal (PLD), ce compte de déclenchement dépassant la gamme des comptes atteints entre des impulsions de restauration qui apparaissent normalement,

3) un circuit de rétablissement de l'alimentation (18, 20), générateur d'un signal (POR) envoyé au système de traitement des données (12) et récepteur d'un signal fourni par le décodeur (52) sur lequel ledit circuit ne répond qu'après un temps fixe quelque soit le moment où intervient le rétablissement de l'alimentation, comprenant:

un circuit comparateur-amplificateur (66) ayant une boucle de réaction allant de sa sortie à sa borne d'entrée positive,

un diviseur de tension (60, 62) pour appliquer un pourcentage prédéterminé de l'alimentation du système à la borne d'entrée positive de ce circuit comparateur-amplificateur,

un circuit de charge RC (58, 64) en série ayant un condensateur (58) connecté entre la borne d'entrée négative de ce circuit comparateur-amplificateur et une borne commune au système et,

un moyen de commutation (18) pour fournir sélectivement un trajet de décharge à ce condensateur, ce moyen de commutation étant commandé par la sortie du décodeur (52),

2. Circuit détecteur selon la revendication 1, caractérisé en ce qu'il comprend en outre des moyens (32) pour redresser la tension d'alimentation alternative à l'entrée appliquée à ce circuit comparateur (26).

3. Circuit détecteur selon la revendication 1 ou 2, caractérisé en ce qu'il comprend en outre un diviseur de tension (36, 38) connecté à la sortie des moyens redresseurs (32) pour démultiplier la tension produite par ces moyens redresseurs.

4. Circuit détecteur selon l'une quelconque des revendications 1 à 3, caractérisé en ce que le circuit comparateur (26) comprend un comparateur-amplificateur (41) ayant une borne d'entrée positive connectée à la sortie du diviseur de tension (36, 38), une borne d'entrée négative connectée à la source de tension de référence continue (30) et un trajet de réaction (48) allant de sa borne de sortie à sa borne d'entrée positive.

5. Circuit détecteur selon la revendication 1, caractérisé en ce que ledit moyen de commutation comprend un transistor (56) dont les bornes d'émetteur et de collecteur sont connectées aux plaques opposées du condensateur (58), et dont la borne de base est connectée à la sortie du décodeur (52).

**Patentansprüche**

1. Fehlerdetektorschaltung auf einer Versorgungsleitung für ein Datenverarbeitungssystem (12), enthaltend:

1) eine Vergleicherschaltung (26), die eine Versorgungswechselspannung mit einer Bezugsgleichspannung vergleicht, sowie Mittel, um nach diesem Vergleich ein Versorgungsfehlersignal (PLD) zu erzeugen, das an das Datenverarbeitungssystem (12) geleitet wird, dadurch gekennzeichnet, dass die Vergleicherschaltung immer dann einen Wiederherstellungsimpuls erzeugt, wenn ein Spitzenwert der Wechselspannung eine Schwelle übersteigt, die durch die Bezugsgleichspannung vorgegeben ist, dass die oben genannten Mittel einen numerischen Zähler (50) enthalten, der einen Eingang des vom Datenverarbeitungssystem (12) kommenden Zeitgebers besitzt, und einen von der besagten Vergleicherschaltung kommenden Wiederherstellungseingang, und der durch den Zeitgeber des Systems (12) inkrementiert wird und auf eine von jedem von der Vergleicherschaltung abgegebenen Wiederherstellungsimpuls (26) vorgegebene Anfangsrechnung zurückgestellt wird,

2) eine Dekodiervorrichtung (52), die auf eine vorgegebene Auslösezahl des numerischen Zählers (50) anspricht, um das besagte Signal (PLD) zu erzeugen, wobei die Auslösungszahl den Bereich der zwischen den normalerweise auftretenden Wiederherstellungsimpulsen erreichten Zählungen überschreitet,

3) eine Schaltung, die die Wiederherstellung der Stromversorgung (18, 20) anzeigt, Vergleicher eines Signals (POR), das an das Datenverarbeitungssystem (12) gesandt wird und Empfänger eines vom Dekoder (52) abgegebenen Signals, auf das die besagte Schaltung erst nach einer festen Zeit anspricht, gleichgültig wann die Wiederherstellung der Versorgungsleitung erfolgt, mit

einer Vergleicher-Verstärkerschaltung (66) mit einer Gegenkopplungsschleife, die von ihrem Ausgang an ihre positive Eingangsquelle geht, einen Spannungsteiler (60, 62), um einen vorgegebenen Prozentsatz der Versorgungsspannung des Systems an die positive Eingangsklemme dieser Vergleicher-Verstärkerschaltung zu legen,

eine Lastschaltung RC (58, 64) in Serie mit einem Kondensator (58), angeschlossen zwischen der negativen Eingangsklemme dieser Vergleicher-Verstärkerschaltung und einer mit dem System gemeinsamen Klemme und

einem Schaltmittel (18), das für diesen Kondensator selektiv einen Entladungsweg bereitstellt und das die Versorgungswechselspannung am an diese Vergleicherschaltung (26) gelegten Eingang gleichrichtet.

2. Detektorschaltung gemäss Anspruch 1, dadurch gekennzeichnet, dass sie ausserdem Mittel (32) enthält, um die Versorgungswechselspannung an dem an diese Vergleicherschaltung (26) gelegten Eingang gleichzurichten.

3. Detektorschaltung gemäss Anspruch 1 oder 2, dadurch gekennzeichnet, dass sie ausserdem einen Spannungsteiler (36, 38) enthält, der an den Ausgang der Gleichrichtermittel (32) angeschlossen ist, um die mit den besagten Gleichrichtermitteln erzeugte Spannung zu teilen.

4. Detektorschaltung gemäss einem der Ansprüche 1 bis 3, dadurch gekennzeichnet, dass die Vergleicherschaltung (26) einen Vergleicher-Verstärker (41) umfasst, der eine positive Eingangsklemme enthält, die an den Ausgang des Spannungsteilers (36, 38) angeschlossen ist, eine negative Eingangsklemme, die an der Quelle der Bezugsgleichspannung (30) angeschlossen ist, und einen Gegenkopplungsweg (48), der von seiner Ausgangsklemme an seine positive Eingangsklemme geht.

5. Detektorschaltung gemäss Anspruch 1, dadurch gekennzeichnet, dass das besagte Schaltmittel einen Transistor (56) enthält, dessen Emitter- und Kollektorklemmen an die entgegengesetzten Platten des Kondensators (58) angeschlossen sind, und dessen Basisklemme an den Ausgang des Dekoders (52) angeschlossen ist.

## Claims

1. A pover line disturbance detector circuit for a data processing system (12) comprising:

(1) a comparator circuit (26) for comparing an AC power voltage with a DC reference voltage, and means for generating, subsequent to said comparison, a power line disturbance (PLD) signal to be applied to said data processing system (12), characterized in that said comparator circuit provides a reset pulse whenever a peak value of the AC voltage exceeds a threshold value established by the DC reference voltage, and in that said means includes a digital counter (50) having a clock input from the data processing system (12) and a reset input from said comparator circuit, said counter being incremented by the clock of said system (12) and being reset to a predetermined initial count by each reset pulse provided by said comparator circuit (26),

(2) decoder means (52) responsive to a predetermined trigger count in said digital counter (50) to generate said PLD signal, said trigger count being beyond the range of counts attained between normally occurring reset pulses,

(3) a Power On Reset (POR) circuit (18, 20) generating a POR signal applied to the data processing system (12) and receiving a signal supplied by said decoder means (52), said circuit responding thereto only after a fixed time interval regardless of when power is restored, comprising:

a comparator-amplifier circuit (66) having a feedback loop from its output terminal to its positive input terminal,

a voltage divider (60, 62) for applying a predetermined percentage of the system power to the positive input terminal of said comparator-amplifier circuit,

a series RC charging circuit (58, 64) having a capacitor (58) connected between the negative input terminal of said comparator-amplifier circuit and a system common terminal, and

switching means (18) for selectively providing a discharge path for said capacitor, said switching means being controlled by the output from said decoder means (52).

2. A detector circuit according to claim 1, characterized in that it further includes means (32) for rectifying the AC power voltage at the input to said comparator circuit (26).

3. A detector circuit according to claim 1 or 2, characterized in that it further includes a voltage divider (36, 38) connected to the output of said rectifying means (32) for scaling down the voltage produced by said rectifying means.

4. A detector circuit according to any one of claims 1 to 3, characterized in that said comparator circuit (26) comprises a comparator-amplifier (41) having a positive input terminal connected to the output of said voltage divider (36, 38), a negative input terminal connected to the source of DC reference voltage (30) and a feedback path (48) from its output terminal to its positive input terminal.

5. A detector circuit according to claim 1, characterized in that said switching means comprises a transistor (56) having its emitter and collector terminals connected to opposite plates of said capacitor (58) and its base terminal connected to the output of said decoder means (52).

# FIG. 1

74V AC

28
REDRESSEUR
DEMULTIPLICATEUR

12V DC

30
REGULATEUR
DE
TENSION

26
COMPARATEUR

+

−

24

REST.

HORL.

16
COMPTEUR/
DECODEUR

+5V DC

20
GENERATEUR
RETABLISSEMENT
ALIMENTATION

POR

22

18
COMMUTATEUR
DE
DECHARGE

10

PLD

12
SYSTEME
ELECTRONIQUE
DE
TRAITEMENT
DE
DONNEES

14

0014 757

FIG. 2